# EUROPÄISCHE PATENTANMELDUNG

(11) **EP 0 621 355 A2**
(43) Veröffentlichungstag der Anmeldung: **26.10.1994**
(21) Anmeldenummer: 94103122.1
(22) Anmeldetag: 02.03.1994
(51) Int. Cl.: C25F 3/12

(54) **Verfahren zur Herstellung einer Lochstruktur in einem Substrat aus Silizium**

(30) Priorität: 29.03.1993 DE 4310205
(71) Anmelder: SIEMENS AKTIENGESELLSCHAFT, D-80333 München (DE)
(72) Erfinder: Hönlein, Wolfgang, Dr., D-82008 Unterhaching (DE); Lehmann, Volker, Dr., D-80689 München (DE); Willer, Josef, Dr., D-85521 Riemerling (DE)

(57) **Zusammenfassung**

Zur Herstellung einer Lochstruktur (6) in einem Substrat (1) aus n-dotiertem, monokristallinem Silizium wird das Substrat (1) durch elektrochemisches Ätzen von einer ersten Hauptfläche (2) ausgehend mit Poren (4) versehen, die eine Tiefe entsprechend der Tiefe der Lochstruktur (6) aufweisen. Auf der ersten Hauptfläche (2) des Substrats (1) wird eine Maske (5) erzeugt, die den Querschnitt de Lochstruktur (6) parallel zur ersten Hauptfläche (2) definiert. Mit Hilfe einer zu Maske (5) selektiven Ätzung wird die Lochstruktur (6) durch Entfernen des die Seitenwände der von der Maske (5) unbedeckten Poren (4) bildenden Siliziums hergestellt.

## Beschreibung

In der Mikrostrukturtechnik stellt sich häufig das Problem, in einem Substrat aus monokristallinem Silizium eine Lochstruktur, auch Kavität genannt, herzustellen, die im wesentlichen senkrechte Wände aufweist. Die Lochstruktur weist dabei einen beliebigen Querschnitt senkrecht zur Tiefe auf. Insbesondere können von den Lochstrukturen auch erhabene Strukturen umfaßt werden, wie dies zum Beispiel bei einem Stempel der Fall ist. Vielfach sollen die Lochstrukturen darüberhinaus ein großes Aspektverhältnis aufweisen. In vielen Anwendungen werden Lochstrukturen mit einer Tiefe von mehr als 10 µm benötigt.

Es ist bekannt, monokristallines Silizium durch Anwendung von naßchemischen Ätzverfahren mit z. B. KOH zu strukturieren. Dadurch lassen sich Lochstrukturen mit Tiefen bis zu 500 µm herstellen. Die Ätzung erzeugt allerdings von der Kristallorientierung des Silizium abhängig schräge Wände oder Böden. Diese Verfahren sind daher zur Herstellung von Lochstrukturen mit im wesentlichen senkrechten Wänden nicht geeignet.

Mit Hilfe von Trockenätzverfahren lassen sich in monokristallinem Silizium Lochstrukturen mit im wesentlichen senkrechten Wänden und parallel zur Tiefe rechteckigem Querschnitt herstellen. Mit Trockenätzverfahren lassen sich allerdings nur Tiefen bis zu etwa 20 µm erzielen. Die erzielbare Tiefe hängt dabei vom Aspektverhältnis ab.

Der Erfindung liegt das Problem zugrunde, ein Verfahren zur Herstellung einer Lochstruktur in einem Substrat aus Silizium anzugeben, mit dem Lochstrukturen mit einer Tiefe über 20 µm unabhängig vom Durchmesser der Lochstruktur herstellbar sind.

Insbesondere sollen Lochstruktur mit großem Aspektverhältnis herstellbar sein.

Dieses Problem wird erfindungsgemäß gelöst durch ein Verfahren nach Anspruch 1. Weitere Ausgestaltungen der Erfindung gehen aus den Unteransprüchen hervor.

In dem erfindungsgemäßen Verfahren werden in einem Substrat aus monokristallinem, n-dotiertem Silizium durch elektrochemisches Ätzen Poren erzeugt. Die Poren werden in einer Tiefe entsprechend der Tiefe der Lochstrukturen hergestellt.

Das elektrochemische Ätzen wird in einem Elektrolyten durchgeführt, mit dem diejenige Fläche des Substrats in Kontakt steht, in der die Poren hergestellt werden. Das Substrat wird bei der elektrochemischen Ätzung als Anode verschaltet. Dadurch bewegen sich Minoritätsladungsträger in dem n-dotierten Silizium zu der mit dem Elektrolyten in Kontakt stehenden ersten Hauptfläche des Substrats. An dieser Fläche bildet sich eine Raumladungszone aus. Da die elektrische Feldstärke im Bereich von Vertiefungen in der Oberfläche größer ist als außerhalb davon, bewegen sich die Minoritätsladungsträger bevorzugt zu diesen Punkten. Dadurch kommt es zu einer Strukturierung der Oberfläche. Je tiefer eine anfänglich kleine Unebenheit durch die Ätzung wird, desto mehr Minoritätsladungsträger bewegen sich wegen der vergrößerten Feldstärke dorthin und desto stärker ist der Ätzangriff an dieser Stelle. Dadurch entstehen Poren, die im Substrat in der kristallographischen 〈100〉-Richtung wachsen. Es ist daher vorteilhaft, ein Substrat mit 〈100〉-Orientierung zu verwenden.

Auf der ersten Hauptfläche des Substrats, die von den Poren durchsetzt ist, wird eine Maske erzeugt, die den Querschnitt für die Lochstruktur parallel zur ersten Hauptfläche definiert. Dieser Querschnitt kann in seiner geometrischen Form frei gewählt werden. Er kann insbesondere von erhabenen Strukturen unterbrochen sein. Anschließend wird die Lochstruktur mit Hilfe einer zur Maske selektiven Ätzung gebildet. Bei der Ätzung wird das Silizium entfernt, das die Seitenwände der von der Maske unbedeckten Poren bildet. In dem erfindungsgemäßen Verfahren wird ausgenutzt, daß die Ätzung jeweils an der gesamten Oberfläche der Poren angreift. Die Seitenwände zwischen benachbarten Poren werden dadurch schneller entfernt, als daß ein nennenswerter Ätzangriff unter die Maske erfolgt. Fur die Ätzung sind sowohl alkalische anisotrope Ätzverfahren als auch saure isotrope Ätzverfahren geeignet.

Bei der elektrochemischen Ätzung entstehen Poren mit Durchmessern von 0,5 bis 5 µm. Der genaue Durchmesser der Poren ist abhängig von der eingestellten Stromdichte im Elektrolyten. Die Poren entstehen mit Abständen von 0,5 bis 5 µm. Die erzielbare Tiefe der Poren hängt von der Ätzzeit ab. Es werden insbesondere Tiefen bis zu 500 µm erreicht. Dieses ist bei Aspektverhältnissen bis zu 1000 möglich.

Die Anordnung der Poren über die erste Hauptfläche kann durch eine Oberflächentopologie beeinflußt werden, mit der die erste Hauptfläche vor der elektrochemischen Ätzung versehen wird. Dabei werden z. B. durch Herstellung einer entsprechenden Fotolackmaske und eine anschließende alkalische Ätzung regelmäßig angeordnete Vertiefungen hergestellt. Bei der elektrochemischen Ätzung wachsen die Poren dann ausgehend von diesen Vertiefungen.

Da keine Oberfläche ideal eben ist, sondern stets leichte Unebenheiten aufweist, entstehen die Poren auch ohne vorheriges Aufbringen einer Oberflächentopologie. Ihre Verteilung über die Fläche ist dann zufällig.

Es liegt im Rahmen der Erfindung, das von der Maske unbedeckte Silizium, das zur Herstellung der Lochstrukturen in der Ätzung entfernt werden muß, nach Herstellung der Maske und vor der Ätzung durch Einbringung von Dotierstoff, zum Beispiel durch Gasphasendiffusion mit einer Dotierung zu versehen. In der isotropen Ätzung wird dann das dotierte Silizium selektiv zu dem umgebenden Silizium entfernt.

Die Gasphasendiffusion erfolgt zum Beispiel mit PH₃ oder POCl₃. Das hoch n-dotierte Silizium wird dann selektiv zu dem schwach n-dotierten Silizium, aus dem das Substrat besteht, mit HF + HNO₃ + CH₃COOH entfernt.

Gemäß einer weiteren Ausführungsform der Erfindung wird nach der Herstellung der Maske vor der Ätzung der freiliegende Bereich zu SiO₂ oxidiert. Die Oxidation erfolgt z. B. thermisch bei 900 bis 1000 °C. Anschließend wird bei der Ätzung das SiO₂ selektiv zu dem umgebenden Silizium entfernt. Dazu ist insbesondere folgender Prozeß geeignet: HF. Bei dieser Ausführungsform ist es vorteilhaft, den Durchmesser der Poren größer als die Wandstärke der die Poren begrenzenden Seitenwänden zu wählen, um die Volumenänderung bei der Oxidation auszugleichen.

Nach der Herstellung der Lochstrukturen wird die Maske entfernt. Um die seitlich der Lochstrukturen verbliebenen Poren zu schließen, liegt es im Rahmen der Erfindung, ganzflächig eine konforme Polysiliziumschicht abzuscheiden.

In dem erfindungsgemäßen Verfahren können Lochstrukturen mit einem Aspektverhältnis (d. h. das Verhältnis von Tiefe zu Durchmesser) bis zu 500 mit senkrechten Wänden hergestellt werden, wobei die Tiefe bis zu 500 µm betragen kann.

Strukturen mit Lochstrukturen mit derartigen Abmessungen werden z. B. in der aus E.W. Becker et al, Microelectronic Engeneering, Bd. 4, (1986), S. 35 ff. bekannten LIGA-Technik benötigt. In der LIGA-Technik wird dazu eine dicke Fotolackschicht mit Hilfe von Röntgenlithographie und Synchrotron-Strahlung strukturiert. Die Herstellung dieser Fotolackstruktur ist dabei kostenintensiv. Diese Fotolackstruktur in dem bekannten LIGA-Verfahren kann durch eine nach dem erfindungsgemäßen Verfahren hergestellte Siliziumstruktur ersetzt werden. Durch galvanisches Abformen oder durch Replikatechniken läßt sich die Form der im Siliziumsubstrat hergestellten Lochstrukturen dabei auf andere Materialien übertragen.

Im folgenden wird die Erfindung anhand der Figuren und der Ausführungsbeispiele näher erläutert.
- Fig. 1: zeigt ein Substrat, das von einer ersten Hauptfläche her mit Poren versehen ist.
- Fig. 2: zeigt das Substrat nach der Herstellung einer Maske.
- Fig. 3: zeigt das Substrat nach der Herstellung einer Lochstruktur.
- Fig. 4: zeigt das Substrat vor der Herstellung der Lochstruktur nach der Dotierung des zu entfernenden Siliziummaterials.
- Fig. 5: zeigt das Substrat vor der Herstellung der Lochstruktur nach der Oxidation des zu entfernenden Materials.

Ein Substrat 1 aus n-dotiertem, monokristallinem Silizium mit einer Dotierstoffkonzentration von etwa 10¹⁵ cm⁻³ wird mit einer ersten Hauptfläche 2 mit einem Elektrolyten in Kontakt gebracht. Der Elektrolyt ist fluoridhaltig und sauer. Er weist eine Flußsäurekonzentration von 1 bis 50 %, vorzugsweise 3 % auf. Dem Elektrolyten kann ein Oxidationsmittel, z. B. Wasserstoffsuperoxid, zugesetzt werden, um die Entwicklung von Wasserstoffbläschen auf der ersten Hauptfläche 2 zu unterdrücken.

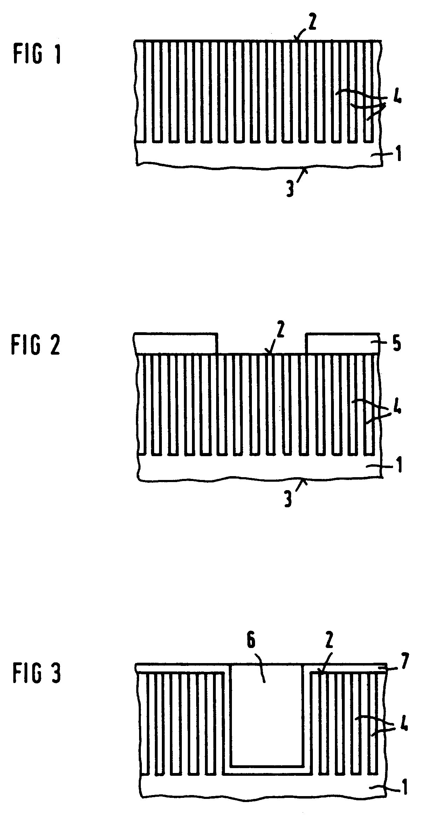

Das Substrat 1 wird als Anode verschaltet. Zwischen das Substrat 1 und dem Elektrolyten wird eine Spannung von 0 bis 20 Volt, vorzugsweise 3 Volt angelegt. Das Substrat 1 wird von einer zweiten Hauptfläche 3, die der ersten Hauptfläche 2 gegenüberliegt her mit Licht beleuchtet, so daß eine Stromdichte von z. B. 10 mA pro cm² eingestellt wird. Ausgehend von Unebenheiten in der ersten Hauptfläche 2, die z. B. gezielt durch Verwendung einer Fotolackmaske und anschließende alkalische Ätzung hergestellt sein können, werden bei der elektrochemischen Ätzung Poren 3 erzeugt, die senkrecht zur ersten Hauptfläche 3 verlaufen (s. Fig. 1). Die Poren werden mit einem Durchmesser von z. B. 1 µm hergestellt. Die benachbarte Poren 4 trennenden Seitenwände weisen eine Dicke von ebenfalls 1 µm Wandstärke auf.

Die elektrochemische Ätzung wird solange fortgesetzt, bis die Poren 4 eine Tiefe von z. B. 500 µm erreichen. Dieses ist nach etwa 720 Minuten der Fall.

Auf der ersten Hauptfläche 2 wird eine Maske 5 aus z. B. Si₃N₄ hergestellt. Die Maske 5 definiert in der Ebene parallel zur ersten Hauptfläche 2 den Querschnitt für eine herzustellende Lochstruktur. Die Maske 5 wird z. B. durch Abscheidung einer Si₃N₄-Schicht und anschließende Strukturierung der Si₃N₄-Schicht unter Verwendung einer Fotolackmaske hergestellt.

Unter Verwendung von HF + HNO₃ wird eine Ätzung durchgeführt, bei der eine Lochstruktur 6 hergestellt wird. Das Ätzmittel dringt dabei in die von der Maske 5 unbedeckten Poren 4 ein. Der Ätzangriff erfolgt über die gesamte Oberfläche der mit dem Ätzmittel in Kontakt stehenden Poren 4. Die benachbarte Poren 4 trennenden Seitenwände, die eine Wandstärke etwa entsprechend dem Durchmesser der Poren aufweisen, werden dabei schneller entfernt, als daß ein nennenswerter Ätzangriff in dem Bereich, der durch die Maske 5 abgedeckt ist, auftritt. Auf diese Weise wird die Lochstruktur 6 mit senkrechten Wänden gebildet, wobei der Querschnitt der Lochstruktur 6 durch die Geometrie der Maske 5 und die Tiefe der Lochstruktur 6 durch die Tiefe der Poren 4 festgelegt wird. Nach Entfernen der Maske 5 wird auf die erste Hauptfläche 2 ganzflächig eine Polysiliziumschicht 7 aufgebracht (s. Fig. 3). Mit der Polysiliziumschicht 7 werden die Poren außerhalb der Lochstruktur 6 verschlossen.

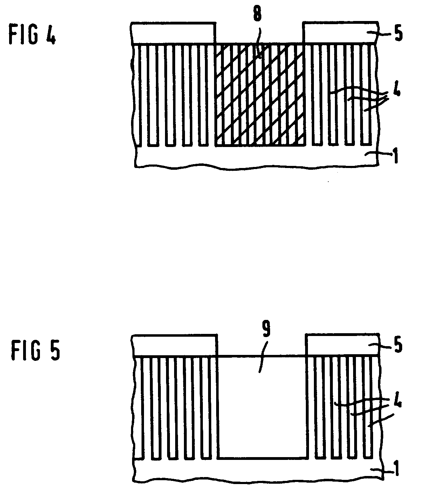

In einer zweiten Ausführungsform der Erfindung wird nach Herstellung der Maske 5 (vgl. Fig. 2) eine Dotierung durchgeführt. Die Dotierung erfolgt z. B. durch Gasphasendiffusion mit PH₃ oder POCl₃. In diesem Fall muß die Maske 5 gegen die PH₃ - oder POCl₃-Diffusion resistent sein. Bei Verwendung von Si₃N₄ für die Maske 5 ist es der Fall. Bei der Gasphasendiffusion wird ein n⁺-dotierter Bereich 8 gebildet. Die Gasphasendiffusion erfolgt bei einer Temperatur zwischen z. B. 900 und 1000 °C wahrend einigen Stunden. Durch die Gasphasendiffusion entlang der Poren 4, die von der Maske 5 nicht abgedeckt sind, kommt es zu einer gleichmäßigen Dotierung in diesen Bereich (s. Fig. 4). Es wird dabei eine Dotierstoffkonzentration von z. B. 10²⁰ cm⁻³ erzielt.

Unter Verwendung von HF + HNO₃ + CH₃COOH wird die Ätzung selektiv zu dem n-dotierten Silizium in dem von der Maske 5 abgedeckten Bereich durchgeführt. Dabei entsteht die Lochstruktur 6. Anschließend werden, wie anhand von Fig. 3 erläutert, die Maske 5 entfernt und eine Polysiliziumschicht 7 zum Verschließen der verbliebenen Poren aufgebracht.

Gemäß einer dritten Ausführungsform der Erfindung wird nach Herstellung der Maske 5 (vgl. Fig. 2) der von der Maske 5 unbedeckte Bereich durch Oxidation in SiO₂ umgewandelt. Dazu wird in Sauerstoffatmosphäre bei z. B. 900 bis 1000 °C eine thermische Oxidation durchgeführt. Dabei entsteht ein SiO₂-Bereich 9 (s. Fig. 5). Auch in diesem Fall wird ausgenutzt, daß die Oxidation über die gesamte Oberfläche der freiliegenden Poren 4 erfolgt. Um Spannungen zu vermeiden, ist es in dieser Ausführungsform vorteilhaft, wenn der Porendurchmesser größer ist als die Dicke der die Poren trennenden Seitenwände. Unter Verwendung von HF wird der SiO₂-Bereich 9 naßchemisch entfernt. Dabei entsteht die Lochstrukturen 6 (s. Fig. 3). Zum Abschluß wird auch in diesem Ausführungsbeispiel die Maske 5 entfernt und eine Polysiliziumschicht zum Verschließen der Poren 4 aufgebracht (s. Fig. 3).

## Patentansprüche

1. Verfahren zur Herstellung einer Lochstruktur in einem Substrat aus Silizium,
- bei dem in dem Substrat (1) aus monokristallinem n-dotiertem Silizium durch elektrochemisches Ätzen in einem Elektrolyten, mit dem eine erste Hauptfläche (2) des Substrats (1) in Kontakt steht, in dem das Substrat (1) als Anode verschaltet ist und in dem eine den Ätzabtrag bewirkende Stromdichte eingestellt wird, Poren (4) erzeugt werden, die eine Tiefe entsprechend der Tiefe der Lochstruktur (6) aufweisen,
- bei dem auf der ersten Hauptfläche (2) des Substrats (1) eine Maske (5) erzeugt wird, die den Querschnitt der Lochstruktur (6) parallel zur ersten Hauptfläche (2) definiert,
- bei dem eine zur Maske (5) selektive Ätzung durchgeführt wird, bei der die Lochstrukturen durch Entfernen des die Seitenwände der von der Maske (5) unbedeckten Poren (4) bildenden Siliziums gebildet wird.

2. Verfahren nach Anspruch 1,
bei dem die Poren (4) mit einem Durchmesser von 0,5 bis 5 µm, einem Abstand kleiner oder gleich dem Durchmesser und einer Tiefe von 5 bis 500 µm gebildet werden.

3. Verfahren nach Anspruch 1 oder 2,
bei dem die Maske (5) aus Si₃N₄ in einem Abscheideverfahren mit schlechter Kantenbedeckung gebildet wird.

4. Verfahren nach einem der Ansprüche 1 bis 3,
bei dem nach der Fertigstellung der Lochstrukturen (6) die Maske (5) naßchemisch entfernt wird und ganzflächig eine Schicht (7) abgeschieden wird, die die Poren (4) verschließt.

5. Verfahren nach einem der Ansprüche 1 bis 4,
bei dem die Ätzung zur Bildung der Lochstrukturen mit HF + HNO₃ durchgeführt wird.

6. Verfahren nach einem der Ansprüche 1 bis 4,
bei dem nach der Herstellung der Maske (5) Dotierstoff eingebracht wird, wobei ein dotierter Bereich (8) erzeugt wird und bei dem die Ätzung zur Bildung der Lochstruktur (6) selektiv zu dem den dotierten Bereich (8) umgebenden Silizium erfolgt.

7. Verfahren nach Anspruch 6,
bei dem eine Dotierstoffdiffusion mit PH₃ oder POCl₃ und die Ätzung mit einem HF + HNO₃ enthaltenden Ätzmittel durchgeführt werden.

8. Verfahren nach einem der Ansprüche 1 bis 4,
bei dem nach der Herstellung der Maske (5) der freiliegende Bereich zu SiO₂ oxidiert wird und bei dem die Ätzung des SiO₂ isotrop zu Silizium erfolgt.

9. Verfahren nach Anspruch 8,
bei dem die Oxidation thermisch bei 900 bis 1000 °C erfolgt und bei dem die Ätzung mit HF durchgeführt wird.

10. Verfahren nach einem der Ansprüche 1 bis 9,
bei dem das elektrochemische Ätzen in einem fluoridhaltigen, sauren Elektrolyten erfolgt.

11. Verfahren nach einem der Ansprüche 1 bis 10,
bei dem das Substrat (1) eine 〈100〉-Scheibe ist.

12. Verfahren nach einem der Ansprüche 1 bis 11,
bei dem die Stromdichte durch Beleuchtung einer der ersten Hauptfläche (2) gegenüberliegenden zweiten Hauptfläche (3) des Substrats (1) eingestellt wird.

13. Verfahren nach einem der Ansprüche 1 bis 12,
bei dem der Elektrolyt 1 bis 50 % Flußsäure (HF) enthält.

14. Verfahren nach Anspruch 13,
bei dem der Elektrolyt zusätzlich ein Oxidationsmittel enthält.
